# EUROPÄISCHE PATENTANMELDUNG

(11) **EP 1 385 079 A2**
(43) Veröffentlichungstag der Anmeldung: **28.01.2004**
(21) Anmeldenummer: 03016722.5
(22) Anmeldetag: 22.07.2003
(51) Int. Cl.: G06F 1/20

(54) **Datenverarbeitungsvorrichtung**

(30) Priorität: 26.07.2002 DE 10234179
(71) Anmelder: Fujitsu Siemens Computers GmbH, 81739 München (DE)
(72) Erfinder: Schestak, Wolfgang, 86456 Gablingen (DE)
(74) Vertreter: Epping Hermann & Fischer

(57) **Zusammenfassung**

Die Erfindung betrifft eine Datenverarbeitungsvorrichtung mit Temperatursensoren (1), mindestens einem Lüfter (2, 3) zur Kühlung der Datenverarbeitungsvorrichtung und einer Kontrolleinheit (4), die mit den Temperatursensoren und den Lüftern verbunden ist und durch die die Lüfter (2, 3) in Abhängigkeit von Meßwerten der Temperatursensoren (1) steuerbar sind, und mindestens einer einen Temperatursensor (6) aufweisenden Festplatte (5). Erfindungsgemäß ist die Datenverarbeitungsvorrichtung dadurch gekennzeichnet, daß eine Schnittstellenvorrichtung (7) vorgesehen ist zur Abfrage des bzw. der Festplattentemperatursensoren (6) und zur Bereitstellung der Temperaturmeßwerte für die Kontrolleinheit (4).

## Beschreibung

Die Erfindung betrifft eine Datenverarbeitungsvorrichtung mit mindestens einem Temperatursensor, mindestens einem Lüfter zur Kühlung der Datenverarbeitungsvorrichtung, einer Kontrolleinheit, die mit dem mindestens einen Temperatursensor und dem mindestens einen Lüfter verbunden ist und durch den zumindest einen Lüfter in Abhängigkeit von Meßwerten des mindestens einen Temperatursensors steuerbar ist und mindestens einer einen Temperatursensor aufweisenden Festplatte.

Moderne Datenverarbeitungsvorrichtungen sind mit einer derartigen, aufwendigen Temperaturkontrolleinrichtung ausgestattet, um auch bei hoher Leistung der Datenverarbeitungsvorrichtung und ihrer einzelnen Komponenten sicherzustellen, daß nicht in einzelnen Bereichen der Datenverarbeitungsvorrichtung bzw. in dem Gehäuse, in das sie aufgenommen ist, Temperaturen auftreten, die zulässige Grenzwerte überschreiten.

In früheren bekannten Datenverarbeitungsvorrichtungen lief die Kühlung immer mit voller Leistung, womit sichergestellt war, daß keine Überhitzung auftreten kann. Problematisch war dabei, daß mit einer hohen Kühlleistung auch eine hohe Geräuschentwicklung verbunden ist. Deswegen wurden neue Datenverarbeitungsvorrichtungen mit einem temperaturabhängig regelbaren Lüfter ausgestattet, der nur dann mit voller Leistung betrieben wird, wenn dies auch erforderlich ist. Bei einer geringen Temperatur der Datenverarbeitungsvorrichtung bzw. in ihrem Gehäuse wird der Lüfter entweder ganz abgeschaltet oder mit einer geringeren Leistung betrieben.

Bei einem Betrieb mit standardmäßig geringer Kühlleistung steigt jedoch die Gefahr, daß einzelne Bereiche der Datenverarbeitungsvorrichtung zu heiß werden. Dies rührt daher, daß einzelne Komponenten sehr stark belastet sind und entsprechend viel Wärme produzieren, während andere Komponenten weniger belastet sind und daher auch weniger Kühlleistung benötigen. Die Belastung einzelner Komponenten hängt sowohl von der jeweiligen Konfiguration der Datenverarbeitungsvorrichtung als auch von der jeweiligen Anwendung ab. Bei einer Anwendung, die eine intensive Verarbeitung von Graphikdaten beinhaltet, wird naturgemäß der Graphikchip stärker belastet als bei einer reinen Textverarbeitungsanwendung.

Um der Vielzahl temperaturkritischer Komponenten gerecht zu werden, sind in Datenverarbeitungsvorrichtungen oft mehrere Temperatursensoren vorgesehen, die an verschiedenen Stellen der Datenverarbeitungsvorrichtung bzw. des Gehäuses Temperaturmeßwerte aufnehmen und zur Steuerung des oder der Lüfter bereitstellen. Als Lüfter ist in der Regel zumindest ein Gehäuselüfter vorgesehen, der meistens in die Stromversorgung integriert ist. Darüber hinaus ist auch ein Prozessorlüfter vorgesehen, der den Hauptprozessor zusätzlich kühlt. Insbesondere bei Servern sind mehrere Lüfter vorgesehen, die der besonders hohen Wärmeentwicklung Rechnung tragen oder die zur hohen Ausfallsicherheit des Gesamtsystems redundant vorgesehen sind.

Problematisch ist jedoch, daß Datenverarbeitungseinrichtungen auch zusätzliche Einbaukomponenten aufweisen, die nicht in das Temperaturregelkonzept der Datenverarbeitungsvorrichtung integriert sind. Besonders kritisch sind hierbei Festplatten, da diese auch eine hohe Temperaturentwicklung aufweisen. Eine hohe Festplattentemperatur wird durch Temperatursensoren detektiert, die im Gehäuse in der Nähe der Festplatte oder am Einbaukäfig angebracht sind. Problematisch ist hierbei, daß zwischen der Entstehung einer unzulässig hohen Temperatur in der Festplatte und dem Erkennen der Grenzwertüberschreitung durch die Temperatursensoren eine verhältnismäßig lange Zeitspanne liegt. Dies kann dazu führen, daß die Festplatte beschädigt wird, ohne daß dies von den Temperatursensoren rechtzeitig erkannt und durch entsprechende Lüftersteuerung vermieden werden könnte. Moderne Festplatten besitzen zwar oft integrierte Temperatursensoren, jedoch sind diese nicht zur Lüftersteuerung verwendbar.

Eine mögliche Lösung des Problems besteht darin, "auf Verdacht" die Lüfter mit einer größeren Leistung zu betreiben, als dies aufgrund der momentanen Temperaturmeßwerte notwendig ist. Dies führt aber wiederum zu einer höheren Geräuschentwicklung, was in der Regel als störend empfunden wird und zu vermeiden ist.

Aufgabe der Erfindung ist es daher, eine Datenverarbeitungsvorrichtung anzugeben, die eine ausreichende Kühlung von Festplatten ermöglicht.

Diese Aufgabe wird durch eine Datenverarbeitungsvorrichtung der eingangs genannten Art gelöst, die dadurch gekennzeichnet ist, daß eine Schnittstellenvorrichtung vorgesehen ist zur Abfrage des bzw. der Festplattentemperatursensoren und zur Bereitstellung der Temperaturmeßwerte für die Kontrolleinheit.

Durch die erfindungsgemäßen Schnittstellen ist es möglich, auch Festplatten in das Temperaturregelungskonzept einer Datenverarbeitungsvorrichtung zu integrieren. Vorteilhaft ist die Schnittstelle so ausgelegt, daß keine zusätzliche Kabelverbindung geschaffen werden muß, um auf den Meßwert des Temperatursensors der Festplatte zuzugreifen, sondern die Schnittstelle so ausgelegt ist, daß ein Zugriff über die Datenschnittstelle der Festplatte möglich ist.

In einer bevorzugten Ausführung handelt es sich dabei um eine Datenschnittstelle nach dem SCSI-Standard.

Durch den direkten Zugriff auf den Temperatursensor der Festplatte wird die Temperatur an dem Ort erfaßt, an dem die Wärme erzeugt wird. Auf Seiten der Festplatten ist keine Änderung erforderlich, wenn die Schnittstellenvorrichtung auf die Datenschnittstelle der Festplatte zugreift. Auf Seiten der Datenverarbeitungsvorrichtung ist lediglich die Kontrolleinheit mit einer geeigneten Schnittstellenvorrichtung zu verbinden, die in der Lage ist, die Datenschnittstelle der Festplatte abzufragen.

Die Erfindung wird nachfolgend anhand eines Ausführungsbeispiels erläutert. Die Figur zeigt eine schematische Darstellung einer erfindungsgemäßen Datenverarbeitungsvorrichtung.

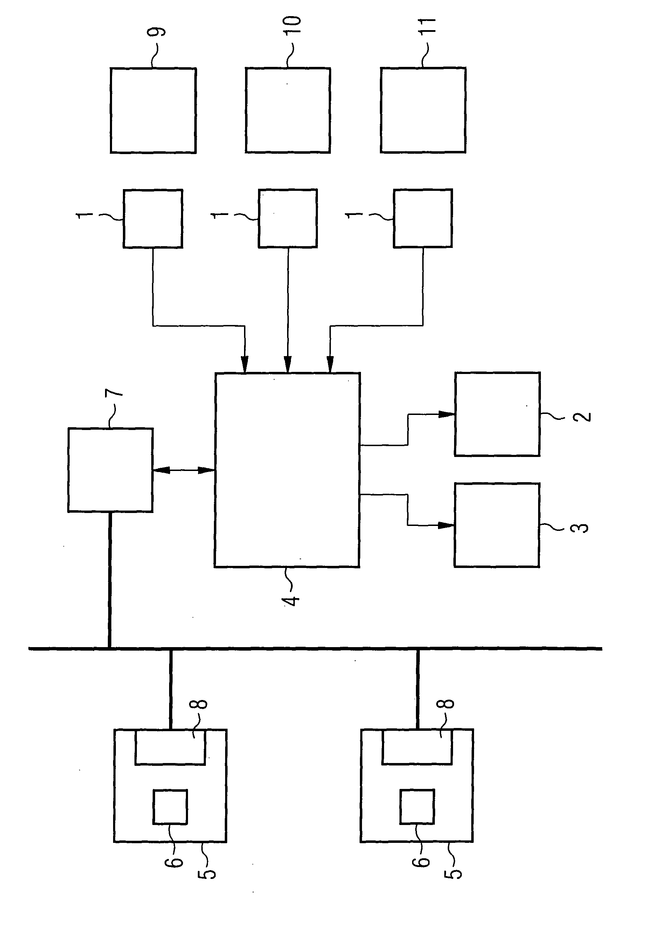

In der Figur 1 sind die für die Erfindung relevanten Komponenten einer Datenverarbeitungsvorrichtung dargestellt. Wärmeerzeugende Komponenten sind beispielsweise eine CPU 9, eine Stromversorgung 10 oder ein Graphikchip 11. Die genannten Komponenten stehen stellvertretend für Stellen innerhalb der Datenverarbeitungsvorrichtung, wo es zu einer lokal erhöhten Wärmeerzeugung kommt und wo daher die Gefahr einer Temperaturgrenzwertüberschreitung besonders hoch ist. In der Nähe dieser "hot spots" sind Temperatursensoren 1 angeordnet. Diese sind mit einer Kontrolleinheit 4 verbunden, die die Temperaturmeßwerte überwacht. Die Kontrolleinheit 4 ist zusätzlich mit Lüftern verbunden. In Figur 1 sind dies ein Gehäuselüfter 2 sowie ein Prozessorlüfter 3. In Abhängigkeit von den gemessenen Temperaturen durch die Temperatursensoren 1 werden die Lüfter 2 und 3 angesteuert. Zusätzlich sind zwei Festplatten 5 vorgesehen, die jeweils über eine SCSI-Schnittstelle 8 verfügen. Über diese Schnittstelle sind die Festplatten 5 über einen nicht gezeigten SCSI-Bus-Verbindung mit der CPU, einem Speicher oder anderen Komponenten zur Datenübertragung verbindbar. Zudem besteht die Möglichkeit, über diese Schnittstelle bestimmte Funktionen der Festplatte zu steuern. Eine dieser Funktionen ist das Auslesen einer augenblicklich von einem Temperatursensor 6, der innerhalb der Festplatte angeordnet ist, gemessenen Temperatur.

Diese Funktion der Festplatten 5 wird erfindungsgemäß ausgenutzt, um die Lüfter 2 und 3 auch in Abhängigkeit von der Temperatur der Festplatten 5 zu steuern. Dazu ist eine zusätzliche Schnittstellenvorrichtung 7 vorgesehen, die auf die SCSI-Schnittstellen 8 der Festplatten 5 zugreifen kann zum Auslesen der Temperaturmeßwerte der Temperatursensoren 6. Die Schnittstellenvorrichtung 7 ist wiederum mit der Kontrolleinheit 4 verbunden, um dieser die entsprechende Steuerung der Lüfter 2 und 3 zu ermöglichen.

Auf Veranlassung durch die Kontrolleinheit 4 sendet die Schnittstellenvorrichtung 7 einen Befehl an die Festplatten 5 zur Ausgabe des augenblicklichen Temperaturmeßwertes. Daraufhin wird der Temperaturmeßwert durch die Festplatten 5 an ihrer SCSI-Schnittstelle 8 bereitgestellt und zur Schnittstellenvorrichtung 7 übertragen. Die Schnittstellenvorrichtung 7 übermittelt die Temperaturmeßwerte in einer geeigneten Form an die Kontrolleinheit 4, so daß diese erkennen kann, ob eine erhöhte Festplattentemperatur vorliegt und in diesem Fall der Gehäuselüfter 2 nachgeregelt werden muß, um eine stärkere Kühlung der Festplatten 5 zu bewerkstelligen.

Durch die erfindungsgemäße Datenverarbeitungsvorrichtung ist sichergestellt, daß die Lüfter nicht mit einer höheren Leistung betrieben werden, als dies zur Kühlung der Festplatten bzw. anderer Komponenten der Datenverarbeitungsvorrichtung notwendig ist.

Selbst wenn eine erhöhte Festplattentemperatur nicht zu einer Zerstörung der Festplatten 5 führt, so verkürzt sich durch die erhöhte Temperatur die Lebensdauer (MTBF: mean-time between failure) der Festplatten 5. Da durch die erfindungsgemäße Integration der Festplatten in die Temperaturregelung der Datenverarbeitungsvorrichtung die Festplattentemperaturen gering gehalten werden können, führt dies zu einer erhöhten Lebensdauer der Festplatten und somit auch zu einer größeren Zuverlässigkeit der Datenverarbeitungsvorrichtung.

### Bezugszeichenliste

- 1: Temperatursensoren
- 2: Gehäuselüfter
- 4: Kontrolleinheit
- 5: Festplatten
- 6: Festplatten-Temperatursensoren
- 7: Schnittstellenvorrichtung
- 8: SCSI-Schnittstellen
- 9: CPU
- 10: Stromversorgung
- 11: Graphikchip

## Patentansprüche

1. Datenverarbeitungsvorrichtung mit
mindestens einem Temperatursensor (1)
mindestens einem Lüfter (2, 3) zur Kühlung der Datenverarbeitungsvorrichtung,
einer Kontrolleinheit (4), die mit dem mindestens einen Temperatursensor (1) und dem mindestens einen Lüfter (2, 3) verbunden ist und durch die der mindestens eine Lüfter (2, 3) in Abhängigkeit von Meßwerten des mindestens einen Temperatursensors (1) steuerbar ist, und
mindestens einer einen Temperatursensor (6) aufweisenden Festplatte (5),
**dadurch gekennzeichnet, daß**
eine Schnittstellenvorrichtung (7) vorgesehen ist zur Abfrage des bzw. der Festplattentemperatursensoren (6) und zur Bereitstellung der Temperaturmeßwerte für die Kontrolleinheit (4).

2. Datenverarbeitungsvorrichtung nach Anspruch 1,
**dadurch gekennzeichnet, daß**
die Schnittstellenvorrichtung (7) auf die Datenschnittstelle (8) der mindestens einen Festplatte zugreift.

3. Datenverarbeitungsvorrichtung nach Anspruch 1,
**dadurch gekennzeichnet, daß**
die Datenschnittstelle (8) nach dem SCSI-Standard ausgebildet ist.
